# EUROPEAN PATENT APPLICATION

(11) **EP 4 841 888 A1**
(43) Date of publication of application: **18.11.2026**
(21) Application number: 26178465.6
(22) Date of filing: 13.05.2026
(51) Int. Cl.: H03D 1/00, H03B 5/00, H10N 30/853

(54) **AIR-PULSE GENERATING DEVICE, DRIVING CIRCUIT AND AIR-PULSE GENERATING SYSTEM**

(30) Priority: 16.05.2025 US 202563806730 P; 11.05.2026 US 202619674050
(71) Applicant: Xmems Labs, Inc., Santa Clara, CA 95051 (US)
(72) Inventor: Liu, Jing-Meng, San Jose, 95129 (US); Ren, Jye, 106 Taipei City (TW); Ng, Eldwin Jiaqiang, Sunnyvale, 94087 (US); Tseng, Kuan-Ju, 300 Hsinchu City (TW)
(74) Representative: Straus, Alexander

(57) **Abstract**

The present application discloses an air-pulse generating device. The air-pulse generating device comprises a first flap (101) and a second flap (102); wherein the first flap is driven by a first driving signal (SV1) and the second flap is driven by a second driving signal (SV2), such that the first flap and the second flap perform a differential-mode movement to form a virtual valve (112); wherein the first driving signal corresponds to a first amplitude and the second driving signal corresponds to a second amplitude; wherein the second amplitude is different from the first amplitude..

## Description

### Field of the Invention

The present application relates to an air-pulse generating device, a driving circuit and an air-pulse generating system, and more particularly, to an air-pulse generating device, a driving circuit and an air-pulse generating system with asymmetric driving amplitude.

### Background of the Invention

Unless otherwise indicated herein, the approaches described in this section are not prior art to the claims in this application and are not admitted as prior art by inclusion in this section.

Piezoelectric materials, such as Lead Zirconate Titanate (PZT), are widely utilized as actuating materials in Micro-Electro-Mechanical Systems (MEMS) devices, including air-pulse generating (APG) devices. In these piezoelectric actuators, critical parameters-including capacitance and the electrical-mechanical coupling coefficient (*e*₃₁)-often exhibit non-linear behavior relative to the applied bias voltage. To achieve electrical, mechanical, or acoustic linearity, driving schemes for piezoelectric devices are frequently implemented using paired components.

However, inherent nonlinearities often lead to significant mismatches in capacitance and electro-mechanical coupling coefficients between the paired actuators. These mismatches result in uneven movement within the pair, manifesting as flap displacement mismatch during both common-mode and differential-mode operations.

Such displacement mismatches lead to several critical performance issues. In devices forming a virtual valve, the mismatch can cause a "false closed status," where the valve remains partially open or experiences significant leakage despite a driving condition intended for a closed state. This is particularly problematic especially when asymmetric initial deflection is required. Furthermore, these inconsistencies contribute to Total Harmonic Distortion (THD) in speaker and ultrasound applications, as well as asymmetrical energy recycling and actuation force imbalance, which ultimately reduces the overall acoustic efficiency of the system.

Therefore, how to mitigate the negative impacts of these inherent mismatches and nonlinearities is a significant objective in the field.

### Summary of the Invention

It is therefore a primary objective of the present application to provide an air-pulse generating device, a driving circuit and an air-pulse generating system, and more particularly, to an air-pulse generating device, a driving circuit and an air-pulse generating system with asymmetric driving amplitude, to improve over disadvantages of the prior art.

An embodiment of the present application discloses an air-pulse generating (APG) device. The APG device comprises a first flap and a second flap; wherein the first flap is driven by a first driving signal and the second flap is driven by a second driving signal, such that the first flap and the second flap perform a differential-mode movement to form a virtual valve; wherein the first driving signal corresponds to a first amplitude and the second driving signal corresponds to a second amplitude; wherein the second amplitude is different from the first amplitude.

An embodiment of the present application discloses a driving circuit. The driving circuit comprises an energy-recycling circuit, comprising an inductor and a switching unit, coupled between a first node and a second node; and a first switch, a second switch, a third switch and a fourth switch; wherein the first and second switches are coupled to the first node, and the third and fourth switches are coupled to the second node; wherein the driving circuit outputs a first driving signal via the first node and outputs a second driving signal via the second node; wherein the first driving signal corresponds to a first amplitude and the second driving signal corresponds to a second amplitude; wherein the second amplitude is different from the first amplitude.

An embodiment of the present application discloses an air-pulse generating system. The air-pulse generating system comprises a driving circuit and an air-pulse generating (APG) device; wherein the APG device comprises a first flap and a second flap; wherein the driving circuit generates a first driving signal to drive the first flap and generate a second driving signal to drive the second flap, such that the first flap and the second flap perform a differential-mode movement to form a virtual valve; wherein the first driving signal corresponds to a first amplitude and the second driving signal corresponds to a second amplitude; wherein the second amplitude is different from the first amplitude.

### Brief Description of the Drawings

FIG. 1 is a schematic diagram of an air-pulse generating device according to an embodiment of the present application.
FIG. 2 is a schematic diagram of an air-pulse generating device possessing an asymmetric initial deflection.
FIG. 3 illustrates nonlinearity of MEMS characteristics with respect to bias voltage.
FIG. 4 illustrates pair mismatch for common-mode movement and differential-mode movement.
FIG. 5 illustrates waveforms of driving signals according to an embodiment of the present application.
FIG. 6 is a schematic diagram of an air-pulse generating system according to an embodiment of the present application.
FIG. 7 illustrates waveforms of voltages, signals, current within the air-pulse generating system shown in FIG. 6.

### Detailed Description

The technical features described in the embodiments of the present invention may be mixed or combined in various ways as long as there are no conflicts between them.

In the present invention, the term "coupled to" may refer to direct or indirect connection. "Component A being coupled to component B" may indicate that component A is directly connected to component B, or component A is connected to component B via some component C.

Content of US Patent No. 12,261,567, Application No. 19/424,094 and No. 19/446,931 is incorporated herein by reference.

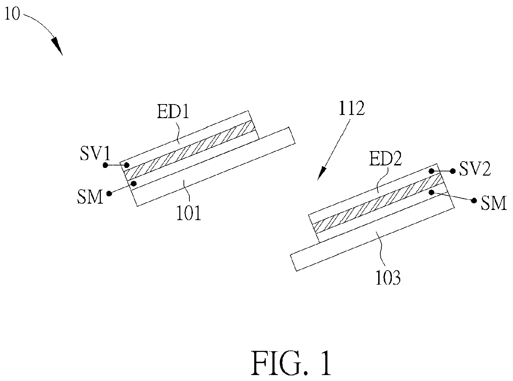

FIG. 1 is a schematic diagram of an air-pulse generating (APG) device 10 according to an embodiment of the present application. The APG device 10 comprises a first flap 101 and a second flap 103, forming a flap pair. The first flap 101 is driven by a first driving signal SV1 via a first electrode ED1 and the second flap 103 is driven by a second driving signal SV2 via a second electrode ED2, such that the first flap 101 and the second flap 103 perform a differential-mode movement to form a virtual valve 112. The driving signals SV1 and SV2 may be considered as valve driving signals or differential-mode driving signals. The first flap 101 and the second flap 103 are also driven by a pressure driving signal SM to perform a common-mode movement. The driving signal SM may also be considered as a common-mode driving signal.

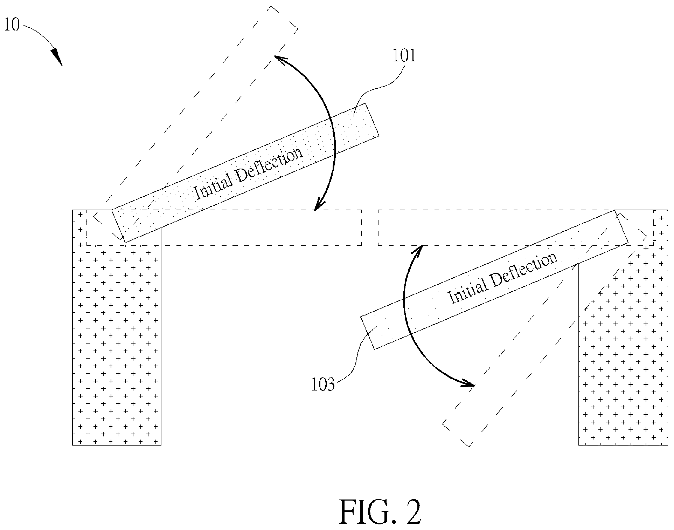

In some embodiments, the first flap 101 and the second flap 103 possess an asymmetric initial deflection when performing the differential-mode movement as shown in FIG. 2, as taught in US Application No. 19/424,094 and No. 19/446,931.

In some embodiments, the asymmetric initial deflection is produced by applying different bias voltage(s) to the driving signals. For example, the asymmetric initial deflection is produced by applying a first bias voltage to the first driving signal SV1 and applying a different second bias voltage to the second driving signal SV2.

Actuating material within actuator(s) disposed on the flap(s) is used. In some embodiments, Lead Zirconate Titanate (PZT), a kind of piezo material, is widely used as actuating material in MEMS (Micro-Electro-Mechanical Systems) device such as the APG device 10.

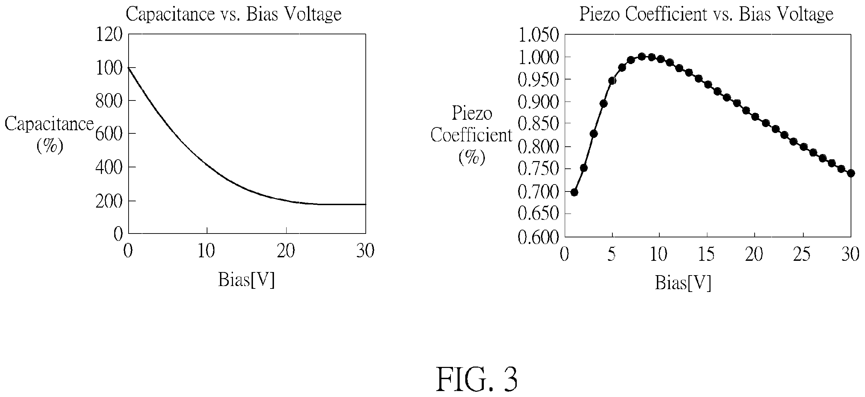

Note that, in a piezoelectric actuator, the capacitance and the electrical-mechanical coupling coefficient (*e*₃₁) are often nonlinear to the bias voltage, which are illustrated in FIG. 3.

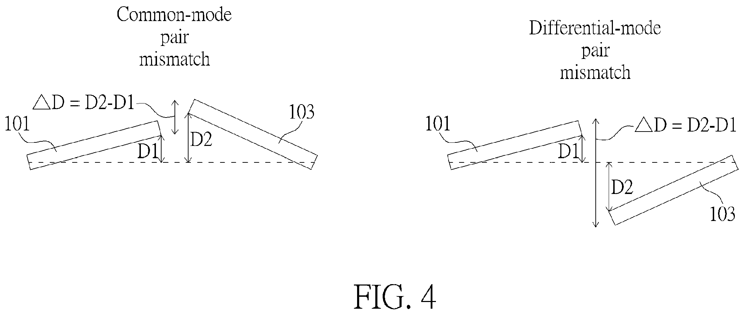

On the other hand, the driver or the driving scheme for a piezoelectric device (e.g., the APG device 10) is sometimes paired for electrical/mechanical/acoustic linearity. The capacitance mismatch and electro-mechanical coupling coefficient mismatch will lead to mismatch in pair movement, e.g., mismatch in common mode movement and/or mismatch in differential mode movement, as illustrated in FIG. 4, where the mismatch herein may be referred to as flap displacement mismatch, namely, ΔD in FIG. 4.

Such displacement mismatch ΔD may cause a false closed status of the virtual valve 112. That is, a driving condition may be provided for the flap pair to form a closed status of the virtual valve 112, but in fact the virtual valve 112 possesses a (significant) leakage/opening due to the displacement mismatch ΔD, especially when the asymmetric initial deflection is required.

This nonlinearity (shown in FIG. 3) and/or mismatch (shown in FIG. 4) manifests in several critical issues, including: (1) Total Harmonic Distortion (THD) in speaker and ultrasound applications; and (2) significant capacitance mismatch in differential pairs, which results in (a) asymmetrical energy recycling and (b) actuation force imbalance, ultimately leading to reduced acoustic efficiency.

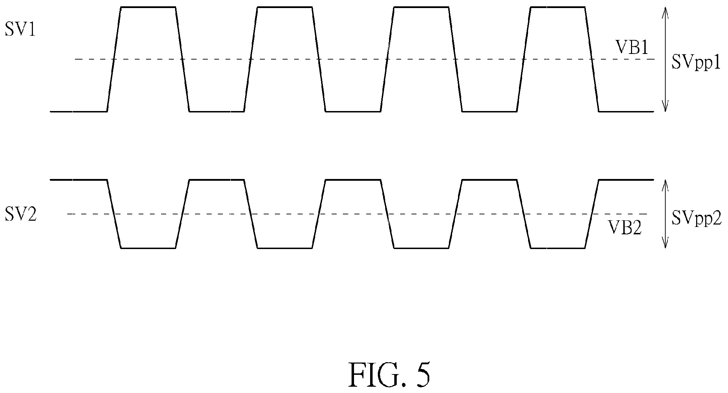

A remedy for such nonlinearity/mismatch is applying the (valve or differential-mode) driving signals with different amplitudes. FIG. 5 illustrates waveforms of the driving signals SV1 and SV2 according to an embodiment of the present invention. As shown in FIG. 5, the driving signal SV1 may have a first AC (Alternating Current) amplitude annotated as SVpp1 and the driving signal SV2 may have a second AC amplitude annotated as SVpp2. Note that, the first AC amplitude and the second AC amplitude are different, i.e., SVpp1 ≠ SVpp2. In addition, the driving signal SV1 may have a first DC (Direct Current) bias voltage denoted as VB1 and the driving signal SV2 may have a second DC bias voltage denoted as VB2.

In an embodiment, VB1 > VB2 (for producing asymmetric initial deflection) and therefore C1 < C2, where C1/C2 denotes capacitance corresponding to the electrode ED1/ED2. In an embodiment, SVpp1 > SVpp2 might be chosen to eliminate the mismatch.

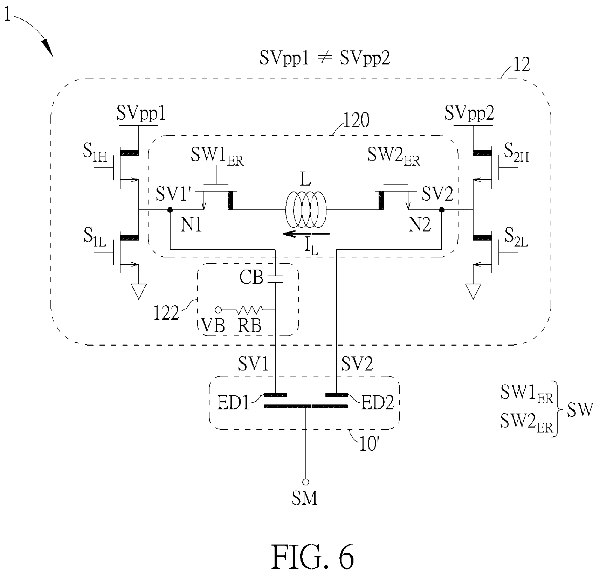

FIG. 6 is a schematic diagram of an air-pulse generating (APG) system 1 according to an embodiment of the present application. The APG system 1 comprises an APG device 10/10' and a driving circuit 12, where the APG device 10' shown in FIG. 6 represents an equivalent circuit abstraction/model of the physical APG device 10 shown in FIG. 1.

In FIG. 6, a valve/differential-mode driving signal generator within the driving circuit 12 is shown. The driving circuit 12 comprises an energy-recycling (ER) circuit 120, comprising an inductor L and a switching unit SW and coupled between a first node N1 and a second node N2. The driving circuit 12 also comprises switches S_{1H}, S_{1L}, S_{2H} and S_{2L}. The switches S_{1H} and S_{1L} are coupled to the first node N1, and the switches S_{2H} and S_{2L} are coupled to the second node N2. The driving circuit outputs the first driving signal SV1 via the first node N1 and outputs the second driving signal SV2 via the second node N2.

To produce the driving signal SV1/SV2 having the first/second AC amplitude, the switch S_{1H}/S_{2H} may receive a first voltage denoted as SVpp1/SVpp2 or at a voltage level of SVpp1/SVpp2; on the other hand, the switch S_{1L}/S_{2L} may receive a second voltage or be coupled to a ground, where the second voltage may be a ground voltage (as shown in FIG. 6) or even a constant voltage.

Furthermore, in order to produce asymmetric initial deflection, the driving circuit 12 may further comprise a bias circuit 122, coupled between the first node N1 and the first electrode ED1. The bias circuit 122 is configured to add a bias voltage VB to a first raw (valve) driving signal SV1' received from the first node N1 and produce the first (valve) driving signal SV1 to the first electrode ED1. The bias circuit 122 comprises a capacitor CB, coupled between the first node N1 and the first electrode ED1, and a resistor RB, coupled to the first electrode ED1 and receiving the bias voltage VB. In an embodiment, SVpp1 > SVpp2.

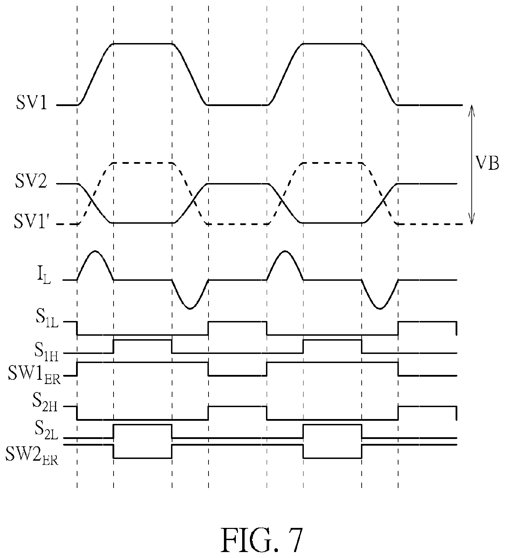

Waveforms of voltages, signals, current within the APG system 1 shown in FIG. 6 are shown in FIG. 7.

Details of the valve/differential-mode driving signal generator may be referred to US Patent No. 12,261,567 and No. 19/446,931.

In summary, by applying driving signals with different AC amplitudes, the system effectively compensates for flap displacement mismatch and resolves issues stemming from piezoelectric nonlinearity.

## Claims

1. An air-pulse generating, abbreviated as APG hereafter, device (10), **characterised by** comprising:
a first flap (101) and a second flap (102);
wherein the first flap is driven by a first driving signal (SV1) and the second flap is driven by a second driving signal (SV2), such that the first flap and the second flap perform a differential-mode movement to form a virtual valve (112);
wherein the first driving signal corresponds to a first amplitude and the second driving signal corresponds to a second amplitude;
wherein the second amplitude is different from the first amplitude.

2. A driving circuit (12), **characterised by** comprising:
an energy-recycling circuit (120), comprising an inductor (L) and a switching unit (SW), coupled between a first node (N1) and a second node (N2); and
a first switch (S_{1H}), a second switch (S_{1L}), a third switch (S_{2H}) and a fourth switch (S_{2L});
wherein the first and second switches are coupled to the first node, and the third and fourth switches are coupled to the second node;
wherein the driving circuit outputs a first driving signal (SV1) via the first node and outputs a second driving signal (SV2) via the second node;
wherein the first driving signal corresponds to a first amplitude and the second driving signal corresponds to a second amplitude;
wherein the second amplitude is different from the first amplitude.

3. An air-pulse generating, abbreviated as APG hereafter, system (1), **characterised by** comprising:
a driving circuit (12) and an APG device (10);
wherein the APG device comprises a first flap (101) and a second flap (102);
wherein the driving circuit generates a first driving signal (SV1) to drive the first flap and generate a second driving signal (SV2) to drive the second flap, such that the first flap and the second flap perform a differential-mode movement to form a virtual valve (112);
wherein the first driving signal corresponds to a first amplitude and the second driving signal corresponds to a second amplitude;
wherein the second amplitude is different from the first amplitude.

4. The APG device of claim 1 or the APG system of claim 3,
**characterised in that** the first flap and the second flap possess an asymmetric initial deflection when performing the differential-mode movement.

5. The APG device of claim 1 or the APG system of claim 3,
**characterised in that** the first driving signal comprises a first bias voltage (VB1) and the second driving signal comprises a second bias voltage (VB2);
wherein the second bias voltage is different from the first bias voltage.

6. The APG device or the APG system of claim 5,
**characterised in that** the first bias voltage is larger than the second bias voltage.

7. The APG device or the APG system of claim 6,
**characterised in that** the first amplitude is larger than the second amplitude.

8. The APG device of claim 1,
**characterised in that** the first flap and the second flap are driven by a pressure driving signal (SM) to perform a common-mode movement.

9. The driving circuit of claim 2,
**characterised in that** the first switch receives a first voltage (SVpp1), and the third switch receives a second voltage (SVpp2);
wherein the first voltage (SVpp1) is different from the second voltage (SVpp2).

10. The driving circuit of claim 2,
**characterised in that** the second switch and the fourth switch are coupled to a ground.

11. The driving circuit of claim 2,
**characterised in that** the driving circuit is configured to drive a first flap (101) and a second flap (102);
wherein the first node is coupled to a first electrode (ED1) disposed on the first flap;
wherein the second node is coupled to a second electrode (ED2) disposed on the second flap.

12. The APG system of claim 3, **characterised in that** the driving circuit comprises:
an energy-recycling circuit (120), comprising an inductor (L) and a switching unit (SW), coupled between a first node (N1) and a second node (N2); and
a first switch (S_{1H}), a second switch (S_{1L}), a third switch (S_{2H}) and a fourth switch (S_{2L});
wherein the first node is coupled to a first electrode (ED1) disposed on the first flap;
wherein the second node is coupled to a second electrode (ED2) disposed on the second flap;
wherein the first and second switches are coupled to the first node, and the third and fourth switches are coupled to the second node;
wherein the first switch receives a first voltage (SVpp1), and the third switch receives a second voltage (SVpp2);
wherein the first voltage (SVpp1) is different from the second voltage (SVpp2).

13. The driving circuit of claim 11 or the APG system of claim 12, **characterised in that** the driving circuit comprises:
a bias circuit (122), coupled between the first node and the first electrode, configured to add a bias voltage (VB) to a first raw driving signal (SV1') received from the first node and produce the first driving signal to the first electrode.

14. The driving circuit or the APG system of claim 13, **characterised in that** the bias circuit comprises:
a capacitor (CB), coupled between the first node and the first electrode; and
a resistor (RB), coupled to the first electrode, receiving the bias voltage.

15. The driving circuit or the APG system of claim 13,
**characterised in that** the first voltage (SVpp1) is larger than the second voltage (SVpp2).
